# EUROPEAN PATENT APPLICATION

(11) **EP 3 840 062 A1**
(43) Date of publication of application: **23.06.2021**
(21) Application number: 19218429.9
(22) Date of filing: 20.12.2019
(51) Int. Cl.: H01L 31/05, H01L 31/02

(54) **COATED METAL RIBBON FOR CONNECTING SOLAR CELLS**

(71) Applicant: Heraeus Deutschland GmbH & Co KG, 63450 Hanau (DE)
(72) Inventor: HANSELMANN, Daniel, 63457 Großauheim (DE); HENNING, Andreas, 63450 Hanau (DE); MATTHEIS, Julian, 65934 Frankfurt am Main (DE)
(74) Representative: Heraeus IP

(57) **Abstract**

The invention relates to a coated metal ribbon for connecting a solar cell, wherein the metal ribbon core has two narrower opposing surfaces and two wider opposing surfaces, wherein a first of the narrower surfaces is coated with a polymer layer and wherein the second narrower surface is coated with a metal layer and wherein the polymer layer and the metal layer are in contact with each other on the two wider opposing surfaces of the metal ribbon core. Furthermore, the invention relates to a method for producing the coated metal ribbon and a photovoltaic component making use of the coated metal ribbon.

## Description

The present invention relates to a coated metal ribbon for connecting solar cells, a process for producing the coated metal ribbon and a photovoltaic component comprising the coated metal ribbon.

Typically, a solar cell consists of at least one semiconductor layer which is contacted by at least two electrodes having different polarities. In most cases, the semiconductor layer is a doped silicon layer which is provided in the form of a monocrystalline or a multicrystalline silicon wafer. Usually, the electrodes having different polarities are located on opposite sides of the semiconductor layer. When the solar cell is exposed to light, there will be a separation of charge in the semiconductor layer, and the charge can be withdrawn from the electrodes as electric current. In order to efficiently collect the charge on the entire surface of the semiconductor layer, the light receiving side is provided with a plurality of thin electrodes spanning the semiconductor layer like a thin grid. These thin electrodes on the light receiving side are also referred to as finger electrodes. Usually, the finger electrodes are very thin to ensure that the surface of the semiconductor layer that is shadowed is as small as possible. Frequently, the finger electrodes have a width in the range of 20 to 150 µm.

In order to efficiently withdraw the charge carriers collected by the finger electrodes, the finger electrodes are connected to one or more bus bars. The bus bars have an increased cable cross-section as compared with the finger electrodes and are mechanically more robust than the finger electrodes. Since they have an increased area and are mechanically robust, they are, among other purposes, used as contact areas for connecting the solar cells. Typically, bus bars have a width in a range from 0.1 to 2 mm. A solar cell can have one or more bus bars. In order to be able to tap higher voltages, several solar cells are connected in series and thereby connected to form photovoltaic modules. In order to connect several solar cells to form photovoltaic modules, the solar cell electrodes of adjacent solar cells are connected by means of a connector, like e.g. metal ribbons.

Typically, the connector is a metal ribbon, more specifically a copper ribbon. The contact among the solar cell electrodes, more specifically the bus bars, is achieved by soldering. To do this, a copper ribbon is completely coated with a thin layer of a solder alloy, e.g., by dip coating; subsequently, this coated copper ribbon is soldered to the electrodes of two solar cells by heating. In the scenario most frequently used, one connector connects the front contact electrode of a first solar cell to the back contact electrode of a further solar cell, wherein the front and back contact electrodes have different polarities. In order to ensure a long service life of the photovoltaic modules, it is desirable that the contact between the connector and the solar cell electrode should have a high mechanical strength and a high electrical conductivity. Most of the time, a connector contacts a mechanically robust bus bar, wherein the bus bar in turn contacts a plurality of finger electrodes. Typically, the bus bar and the connector are connected to each other by soldering.

In order to achieve the lowest possible shadowing of the active semiconductor layer of the solar cell, the trend is towards ever more and ever thinner bus bars. If connector and bus bar have the same width and conventional connectors that are completely coated with solder alloy are used, liquid solder may flow beyond the bus bar during the soldering process and, in addition, wet one or more finger electrodes. When getting into contact with the liquid solder alloy, a finger electrode may be damaged both chemically and mechanically. For example, corrosion may result in a reduction in conductivity or a complete interruption of the contact. This leads to the fact that collected electrical charges cannot be removed from the region of the interrupted finger efficiently or not at all and, consequently, the efficiency of the solar cell is reduced. Even if the finger electrode is not damaged directly when contacting the solder alloy, the probability increases that thermal alternating stress due to corrosion will cause interruption of the over-soldered finger during operation of the solar cell.

In general terms, an object of the present invention is to at least partly overcome at least one of the disadvantages that are known from the prior art.

In view of the above it is an object of the invention to provide an improved metal ribbon for connecting solar cells which decreases the shadowing of the active area of a solar cell.

It is a further object of the invention to provide a metal ribbon for connecting solar cells which can be easily prepared.

It is a further object of the invention to provide a metal ribbon which exhibits high conductivity.

Furthermore, it's an object to provide photovoltaic component which has improved power conversion efficiency compared to a photovoltaic component which is connected through state-of-the-art connectors.

A contribution to the solution of at least one of the above objects is provided by the subject-matter of the category-forming embodiments. The dependent sub-embodiments of the category-forming embodiments represent preferred embodiments of the invention, the subject-matter of which also makes a contribution to solving at least one of the objects mentioned above.

### Preferred Embodiments

I. Coated metal ribbon for connecting a solar cell, wherein the ribbon has two narrower opposing surfaces and two wider opposing surfaces, wherein a first of the narrower surfaces is coated with a polymer layer and wherein the second narrower surface is coated with a metal layer and wherein the polymer layer and the metal layer are in contact with each other on the two wider opposing surfaces.
II. Coated metal ribbon according to any one of the preceding embodiments, wherein the metal layer comprises a solder alloy or consists of a solder alloy.
III. Coated metal ribbon according to any one of the preceding embodiments, wherein the polymer layer comprises a solder resist or consists of a solder resist.
IV. Coated metal ribbon according to any one of the preceding embodiments, wherein the coated metal ribbon has a metal ribbon core that comprises copper or consists of copper.
V. Coated metal ribbon according to any one of the preceding embodiments, wherein the polymer layer further comprises inorganic particles having a diameter in the range from 100 nm to 50 µm.
VI. Method for producing a coated metal ribbon according to any one of embodiments I - V comprising the steps:
   a. Providing a metal ribbon core,
   b. Applying a polymer layer on the first narrower surface of the metal ribbon core, and
   c. Applying a metal layer on the second narrower surface of the metal ribbon core.
VII. Method for producing a coated metal ribbon according to embodiment VI, wherein steps b) and c) are performed such that the metal layer and the polymer layer contact each other on both of the wider surfaces of the coated metal ribbon.
VIII. Method for producing a coated metal ribbon according to embodiment VI or VII, wherein the metal ribbon core is cleaned before step b) and preferably the cleaning a comprises plasma cleaning.
IX. Method for producing a coated metal ribbon according to any one of embodiments VI - VIII, wherein the polymer layer is applied by printing or immersion.
X. Method for producing a coated metal ribbon according to any one of embodiments VI - IX, wherein the metal layer is applied galvanically or by immersion.
XI. A photovoltaic component, comprising a first solar cell electrode and a further element, wherein the solar cell electrode and the further element are connected to each other by means of a coated metal ribbon according to any one of embodiments I - V.
XII. A photovoltaic component according to embodiment XI, wherein the coated metal ribbon is positioned symmetrically on the solar cell electrode.
XIII. A photovoltaic component according to embodiment XI or XII, wherein the coated metal ribbon is positioned on a solar cell electrode such that it partially overlaps with the solar cell electrode and the metal layer is in contact with the solar cell electrode.
XIV. A photovoltaic component according to any one of embodiments XI -XIII, wherein the solar cell electrode is positioned at the edge of the solar cell substrate and the part of the coated metal ribbon which is coated with the polymer layer extends beyond the edge of the solar cell substrate.

### Detailed description

Ranges mentioned in the present context includes the values specified as limits. Thus, an indication of the type "in the range from X to Y" with respect to a size A means that A can assume the values X, Y and values between X and Y. One-sided limited ranges of the type "up to Y" for a size A include in analogous manner the value of Y and those values smaller than Y.

A first aspect of the invention is directed to a coated metal ribbon for connecting a solar cell, wherein the ribbon has two narrower opposing surfaces and two wider opposing surfaces, wherein a first of the narrower surfaces is coated with a polymer layer and wherein the second narrower surface is coated with a metal layer and wherein the polymer layer and the metal layer are in contact with each other on the two wider opposing surfaces.

The coated metal ribbon of the invention may be used for connecting solar cells. Therefore, they are sometimes termed solar cell connectors. Typically, the coated metal ribbons are soldered to solar cell electrodes. For example, the coated metal ribbon may connect the back side electrode of a first solar cell with the front side electrode of a second electrode. Alternatively, the coated metal ribbon may connect a solar cell electrode to a further element of a photovoltaic module.

In some embodiments the metal ribbon has a metal ribbon core. The metal of the metal ribbon core may be an elemental metal or an alloy. Preferably the metal of the ribbon core is selected from the group consisting of copper, silver, aluminium, zinc and gold.

In a particularly preferred embodiment, the metal ribbon core comprises copper or consists of copper. If the metal ribbon core consists of copper this means that the ribbon core comprises at least 99.90 wt.-% copper. In a preferred implementation of the invention, the metal ribbon core can be made of copper that meets the industry standards Cu-ETP or Cu-OFC.

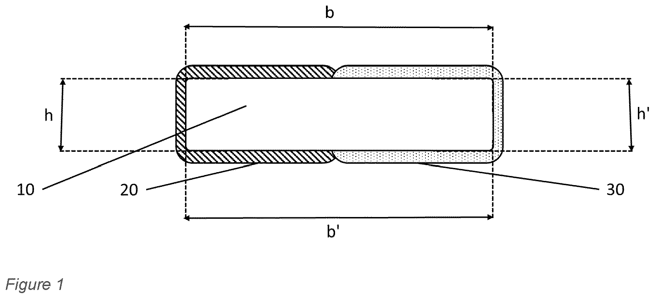

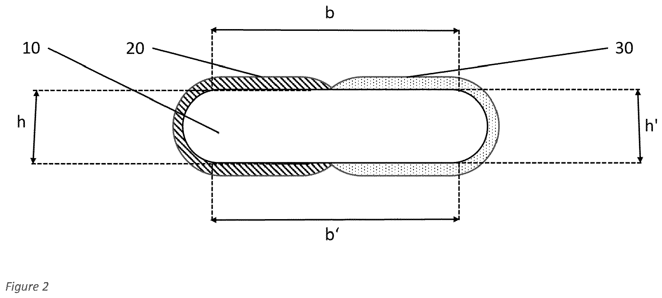

The coated metal ribbon for connecting a solar cell, has two narrower opposing surfaces and two wider opposing surfaces. Preferably the wider surfaces have the same width. Preferably the narrower surfaces have the same width. The wider surfaces are preferably plane surfaces. The plane surfaces are preferably oriented parallel to each other. The narrower surfaces may be plane or round. If the narrower surfaces are plane, they are preferably oriented parallel to each other. A metal ribbon core having rounded narrower surfaces may be obtained for example by rolling a round wire between two parallel rolls. Exemplary cross-sections of metal ribbon cores with the described geometry are illustrated in Figures 1 and 2. In Figures 1 and 2 the metal ribbon core is already coated.

The width of the wider surfaces is preferably at least twice as long as the width of the narrower surfaces.

The preferred width of the narrower surface is in the range from 0.1 mm to 0.4 mm, especially in the range from 0.16 mm to 0.3 mm. The width of the wider surface is preferably are in the range from 0.6 to 2.0 mm, especially in the range from 0.9 to 1.5 mm.

The length of the metal ribbon is not further limited. Preferably, the metal ribbon core has a length which is sufficient to connect two adjacent solar cells to each other via their electrodes, more specifically via their bus bars. Therein, the length of the metal ribbon core can, for example, be twice as long as the length of a solar cell to be connected. In some embodiments the metal ribbon of the invention has a length in the range from 100 to 600 mm and preferably in the range from 200 to 400 mm.

Preferably, the metal ribbon core has one or more of the following mechanical properties:
- A tensile stress Rm within a range from 100 to 300 MPa, preferably no more than 280 MPa.
- A yield point Rp0.2 within a range from 40 to 120 MPa, preferably no more than 80 MPa.
- An elongation at fracture A100 within a range from 10 to 40%, preferably no less than 25%.

According to the first aspect of the invention a first narrower surfaces of the metal ribbon core is coated with a polymer layer. In a preferred embodiment the polymer layer has no holes or defects. More preferably the polymer layer is applied such that it shields the metal ribbon core surface from environmental influences, like e.g. humidity or oxygen.

The polymer layer may comprise polymer or consist of polymer. More specifically, the polymer of the polymer layer is selected such that it is not wetted by molten solder alloy. The polymer can contain a homopolymer or a copolymer. The polymer can have thermosetting or thermoplastic properties. In general, thermosetting materials are understood to mean such materials which cannot be deformed when heated. More preferably, the polymer material is a thermosetting material. Preferably, thermosetting materials are produced by chemically cross-linking resins, more particularly artificial resins and natural resins. Preferably, artificial resins are selected from epoxy resins, polyester resins and acrylic resins. The resin can be a single-component or multi-component system. Preferably, the curing or cross-linking of the resin is initiated by UV light, heat or by adding a further component. The further component can, for example, be a cross-linking agent, a catalyst or an initiating agent. More preferably, the polymer material is a cross-linked coating, such as a solder resist. In the regions in which it is applied, a solder resist can prevent the surface of the metal ribbon core from being wetted with molten solder alloy. Preferably, the solder resist can contain a cured, more specifically cross-linked epoxy resin. Most preferably, the polymer that is used for the polymer layer is UV-cured, i.e., the resin used cures under the effect of UV light (wavelength of about 200 nm to 400 nm).

In a preferred embodiment, the polymer of the polymer layer has an elastic modulus of 7 GPa or less, more preferably 5 GPa or less and most preferably 2 GPa or less. Preferably, the content of polymer in the coating on the complete surface of the metal ribbon core is 5 to 95% and, preferably, 30 to 80% of the complete surface of the metal ribbon core.

In a preferred embodiment, the polymer material comprises at least one filler. The at least one filler can be an organic or an inorganic filler. In particular, the filler can be present in the form of particles. The inorganic filler can, for example, be a metal oxide. In some embodiments the metal oxide may be selected from the group consisting of TiO₂, ZnO, SiO₂, ZrO₂, SnO₂, CaO, and Al₂O₃ or mixtures thereof. Preferably, the filler has light-scattering properties. In a preferred embodiment the filler has a particle size d₅₀ in the range from 100 nm - 50µm. Preferably, the filler is present as particles distributed in the polymer layer. Since it is a dielectric material, the polymer acts as an isolator. Therein the effect of the isolator refers to the layer of material as a whole. The polymer preferably is not wetted by a metal melt. According to the invention, it cannot be excluded that the polymer layer, comprises metallic particles as filler. Preferably, the filling degree of the metallic particles in the polymer layer is kept so low that the layer of the polymer as a whole does not have an increased electric conductivity as compared with an unfilled polymer layer. Preferably, the metallic particles scatter the visible light, more specifically the sunlight incident on the coated metal ribbon and, preferably, do not melt at the soldering temperature of the solder material either.

If the polymer contains a light-diffusing filler, sunlight incident on the coated metal ribbon can be scattered in such a way that it does not leave the solar cell or the photovoltaic module, but instead reaches the active semiconductor layer by internal reflection and generates additional charge carriers. Thereby, the efficiency of the solar cell can be increased.

Preferably, the layer thickness of the polymer layer is within a range from 1 µm to 40 µm, more preferably within a range from 10 µm to 20 µm. More preferably, the layer thickness of the polymer layer corresponds to the layer thickness of the metal layer.

According to the first aspect of the invention the second of the narrower surfaces of the metal ribbon core is coated with a metal layer. In a preferred embodiment the metal layer has no holes or defects. More preferably the metal layer is applied such that it shields the metal ribbon core surface from environmental influences, like e.g. humidity or oxygen.

The metal layer preferably comprises a solder material. Preferably, the solder material contains a solder alloy or consists of a solder alloy. A solder alloy is a metallic mixture of elements at least one of which is a metal. Preferably, all elements of the alloy are metals. Preferably, the solder alloy has a melting point that is at least 100 °C, more preferably at least 200°C, lower than the melting temperature of the metal ribbon core. Preferred solder alloys contain elements which are selected from the group consisting of Sn, Pb, Ag, Bi, Cu, Zn, Au, Sb, Cd, Co, and Al. Preferably, the solder alloy consists of at least two of these elements. Particularly preferred solder alloys are selected from the group containing SnPb, SnPbAg, SnPbBi, SnAg, SnAgBi, SnAgCu, SnBi, and SnCu. The solder alloy can be selected from lead-containing solder alloys or from lead-free solder alloys. Particularly preferred lead-containing solder alloys are selected from the group consisting of Sn₆₂Pb₃₆Ag₂, Sn₆₃Pb₃₇, and Sn₆₀Pb₄₀. Particularly preferred lead-free solder alloys are selected from the group consisting of Sn_{96,5}Ag_{3,5}, Sn_{96,5}Ag₃Cu_{0,5}, Sn₆₀Bi₄₀, Sn₅₀Bi₄₈Ag₂, Sn₄₂Bi₅₇Ag₁, Sn₄₃Bi₅₇, Sn₅₀Bi₅₀, and Sn99,3Cu_{0,7}. The solder material can consist of the solder alloy except for unavoidable contaminants. Preferably, the total amount of the components of the metal layer that cannot be attributed to the solder alloy is no more than 0.1 weight per cent, more specifically no more than 0.01 weight per cent.

Alternatively, the solder material can contain a solder alloy, wherein the solder material additionally contains other components. The solder material may comprise substances selected from the group consisting of fluxing agents, solvents and other additives. Preferably, the fluxing agent is selected from organic acids, such as colophony or adipic acid, inorganic salts, such as ammonium chloride, and inorganic acids, such as phosphoric acid. Preferably, the fluxing agents are free from halides. Preferably, the solvent is an organic or aqueous solvent. Preferably, the additives are activators. Known activators are, for example, halide-containing compounds. Preferably, the content of the aforementioned other substances of the solder material (e.g., fluxing agents, solvents and activators) is within a range of 1 weight per cent or less, more specifically 0.1 weight per cent or less. In a preferred embodiment, the other components in the solder material can be residues of a soldering paste, such as it is described in the method for producing the coated metal ribbon according to the invention.

Preferably, the average layer thickness of the metal is within a range from 1 µm to 40 µm and more preferably within a range from 10 µm to 20 µm.

According to the invention the polymer layer and the metal layer are in contact with each other on the two wider opposing surfaces of the metal ribbon core. This is illustrated in Figures 1 and 2 which shows two possible cross-sections of a coated metal ribbon. In both cases the polymer layer 20 and the metal layer 30 each coat one of the narrower surfaces of the metal ribbon core and both layers 20 and 30 extend to the wider surfaces of the metal ribbon core where the polymer layer and the metal layer are in contact with each other. In this way the metal ribbon core is fully coated around its circumference.

In a preferred embodiment of the invention the with of the polymer layer and the with of the metal layer are the same. Alternatively the with of the metal layer may cover 30 -70 % of the surface of the metal ribbon core and the polymer layer may cover the remaining surface of the metal ribbon core.

In a preferred embodiment the metal layer covering the narrower surfaces has the same extension on both of the wider opposing surfaces of the metal ribbon core. Alternatively the extension of the metal layer on both of the wider opposing surfaces of the metal ribbon core is different. Preferably the extension on the wider opposing surfaces of the metal ribbon core differs by 50% or less.

Compared to scenarios where the metal ribbon core comprises two or more stripes of a polymer layer and a metal layer on the surface, the simplified design of the present invention where the polymer layer and the metal layer are in contact with each other on the two wider opposing surfaces, reduces the tendency for defects in the regions where polymer layer and metal layer are in contact.

In a second aspect the invention relates to a process for producing the coated metal ribbon of the invention comprising the steps
a) Providing a metal ribbon core having two narrower opposing surfaces and two wider opposing surfaces,
b) Applying a polymer layer on the first narrower surface of the metal ribbon core, and
c) Applying a metal layer on the second narrower side of the metal ribbon core to obtain a coated metal ribbon,
wherein the metal layer and the polymer layer are brought in contact with each other on both of the wider surfaces of the metal ribbon core.

In a preferred embodiment the metal ribbon core provided in a) is cleaned before step b) and thereby residues, e.g., oils and oxides, are removed. Preferably the cleaning is plasma cleaning. The plasma may be for example an argon plasma.

In the method according to the invention, step a) is necessarily performed prior to steps b) and c). The order of steps b) and c) is not defined any further. This is also expressed by the term "comprising". In a preferred embodiment, step b) is precedes step c).

The method according to the invention does not exclude that further steps are performed prior to, between or subsequent to steps a) to c).

In step a), a metal ribbon core such as it is described herein is provided. Preferably, the metal ribbon core is provided as a continuous ribbon on a reel. Preferably, the rolled-up metal ribbon core can have a length of several hundreds to several thousands of meters. If the metal ribbon core is provided in the form of a roll, the metal ribbon core is preferably unrolled from the roll in step a). In a more preferred embodiment, step a) additionally includes a pre-treatment. The pre-treatment can, for example, be selected from soft-annealing and plasma etching in an inert atmosphere. An inert atmosphere can, for example, be a nitrogen or argon atmosphere. If the metal ribbon is treated by soft-annealing and plasma etching, the entire process for producing the coated metal ribbon is preferably performed in an inert atmosphere.

In step b), a polymer layer is applied on a first narrower surface of the metal ribbon core. In a preferred embodiment the narrower surface is fully covered with polymer layer and the polymer layer further extends onto the wider surfaces.

Preferably, the application of the polymer layer in step b) has two sub-steps. In the first sub-step, a polymer material or a precursor of the polymer is applied onto the metal ribbon core while, in the second sub-step, the polymer material or a precursor of the polymer is fixed on the metal ribbon surface. A cross-linkable resin (more specifically, an artificial resin) or a solder resist is preferably applied onto the metal ribbon core. A cross-linkable resin and a lacquer can be precursors for the polymer, which can be fixed in a further sub-step. The solder resist can be a solder resist which prevents the surface of the metal ribbon core from being wetted with liquid solder alloy in the applied regions.

Preferably, the polymer layer is applied by printing or by means of conventional extrusion methods. The printing method can be a contact printing method or a contactless printing method. The contact printing method can be selected from the group consisting of relief printing, flat printing (e.g., offset printing) and gravure printing. In one embodiment, each of the aforementioned printing methods can be carried out as a batch wise printing method. Preferably, polymer is applied onto the metal ribbon core continuously, i.e., in a roll-to-roll method. To achieve this, it is advantageous to continuously feed the metal ribbon core to a printer head. The printer head has corresponding cut-outs in which the metal ribbon core can be coated with polymer or the polymer precursor. The regions of the metal ribbon core outside the cut-outs are kept free from the coating with polymer or polymer precursor by means of covers or by introducing a flow of gas or solvent.

In a further preferred embodiment, polymer material or the precursor of the polymer layer can be applied onto the metal ribbon core by means of a contactless printing method. The contactless printing method can, be selected from the group consisting of spraying, inkjet printing or dispensing.

In a further preferred embodiment, the polymer can be applied onto the metal ribbon core in the form of a film which is laminated onto the metal ribbon core.

Optionally, the layer of polymer material or the precursor of the polymer layer is fixed on the metal ribbon core in a second sub-step. This fixing step can cause a change in the chemical structure that has been applied in the first sub-step, for example, by a cross-linking reaction of a polymer precursor to form a polymer network.

A polymer material that has been applied in the form of a resin or lacquer in the first sub-step can preferably be fixed by UV radiation (e.g., by means of a broadband UV emitter) or by supplying heat. UV-radiation in this context is to be understood as electromagnetic radiation having a wavelength in the range from 100 - 400 nm. Preferably, there is a cross-linking reaction while the resin or lacquer is being fixed.

In case a polymer film is applied onto the metal ribbon core, the polymer film is preferably fixed on the surface of the metal ribbon core. More particularly, the polymer film is heated up to its melting temperature, at least in part. Preferably, the adhesion of the polymer film with respect to the metal ribbon core is increased by heating. In an alternative preferred embodiment, the polymer film is not treated in a further sub-step.

By fixing the polymer material or a precursor of polymer material that has been applied in the first sub-step on the metal ribbon core, the adhesion of that layer to the metal ribbon core can be increased in the second sub-step and the layer of polymer can itself be made more resistant to mechanical and chemical influences.

In another preferred embodiment of step b), the metal ribbon core is, first, completely coated with a polymer layer and, then, the polymer layer is partially removed again, resulting in a partial coating of the metal ribbon core with a polymer layer. The partial removal can, for example, be achieved by means of laser ablation. In a most preferred embodiment, the metal ribbon core is, first, completely coated with a precursor of polymer material, more particularly with a solder resist, wherein the latter is fixed, more particularly cross-linked; then, the fixed polymer material is partially removed by means of laser ablation. This laser ablation partially uncovers the surface of the metal ribbon core.

In a preferred embodiment, the polymer layer applied has a modulus of elasticity of 7 GPa or less, more preferably 5 GPa or less and most preferably 2 GPa or less after the fixing step. Preferably, the polymer layer coats between 5 and 95%, preferably between 30% and 80% of the overall surface of the metal ribbon core.

In a more preferred embodiment, step c) is preceded by a pre-treatment. The pre-treatment can, for example, include the application of a fluxing agent onto the regions of the metal ribbon core that are not coated with the polymer layer. This application may, in particular be required if the process for producing the coated metal ribbon is not entirely carried out in an inert gas atmosphere. Preferably, an inert gas atmosphere does not contain more than 1 percent by volume of oxygen.

In step c) a metal layer is applied on the second narrower surface of the metal ribbon core. In a preferred embodiment the second narrower surface is fully covered with the metal layer and the metal layer further extends onto the wider surfaces.

Preferably, the metal ribbon core is coated with the metal layer in the regions that are not coated with the polymer layer. In case of a copper ribbon core, preferably nothing but the exposed copper surface is covered with the metal layer. The polymer layer, preferably a cured solder resist, is preferably not wetted by liquid molten solder alloy.

The metal ribbon core can be coated with the metal layer in different ways. In a preferred embodiment, the metal ribbon core that has already been coated with a polymer layer is coated with a metal layer. The metal ribbon core can be coated with a metal layer by dip coating. When dip coating is used, the metal ribbon core already coated with a polymer layer can be dipped, i.e. immersed, into a liquid bath of molten solder alloy or a bath of solder paste. Dip coating is advantageous in that it is particularly easy to make defined regions of a metal layer on the metal ribbon core that has already been coated with a polymer layer. During dip coating, the regions of the metal ribbon core not coated with the polymer layer can be coated with the metal layer. Preferably, the metal ribbon core is dipped into a bath of liquid solder alloy. Preferably, the metal ribbon core, more specifically the copper ribbon core, is continuously passed through a molten bath of solder alloy. Preferably, the solder alloy of the molten bath has a melting point that is at least 100 °C, more specifically at least 200°C, lower than the melting temperature of the metal ribbon core. The solder alloy can be selected from solder alloys that are described herein.

In some embodiments, excess liquid solder alloy on the metal ribbon core can be removed, for example by means of compressed air or by wiping off. Preferably, the layer of liquid solder alloy on the metal ribbon core has the same or at least a similar layer average thickness as the polymer layer. In an alternative embodiment, the average thickness of the metal layer exceeds that of the polymer layer. The polymer layer can have a uniform or a varying layer thickness.

After having passed through the molten bath, the liquid solder alloy can cool down and solidify, with the result that a solder layer is formed on the metal ribbon core.

In an alternative embodiment of the invention, the metal ribbon core that has already been coated with a polymer layer can be coated with a solder paste by printing. Preferably, the solder paste contains at least particles of a solder alloy and a fluxing agent. Furthermore, the solder paste can comprise solvents and additives. The solvents can be organic or aqueous solvents. The additives can, preferably, be rheology modifiers, such as thixotroping agents, thickeners or resins. The solvent can be an organic solvent or an aqueous solvent.

In a first step, the solder paste is printed onto the regions of the metal ribbon core that are not coated with the polymer layer. In a further step after the coating step, the solder paste can be fixed on the metal ribbon core. Preferably, the solder paste is fixed by warming or heating. In this context, warming is understood to mean that the solder paste is warmed up to below the melting point of the solder alloy contained therein, with the result that the layer of the paste dries and volatile components escape. In this context, heating is understood to mean that the layer of the solder paste is heated up to over the melting point of the solder alloy contained therein. Preferably, a continuous layer of a solder alloy is formed during heating while the volatile components of the paste are removed to the greatest possible extent, e.g., by evaporating or burning. In this way, a coated metal ribbon according to the invention can be produced.

As mentioned above, the order of steps b) and c) is not defined any further. In a possible embodiment of the invention, the coated metal ribbon can be produced by first applying a metal layer and then a polymer layer is applied. This processing order can be realised, for example, by first applying a metal material in the form of a metal paste on a first narrower surface of the metal ribbon core and then the polymer layer is applied in the regions of the metal ribbon core not coated with the metal layer. In this embodiment in which step b) follows step c), both the polymer layer and the metal layer are preferably applied by printing.

If the metal ribbon core is provided as a continuous ribbon in step a), the coated metal ribbon after coating is preferably cut into individual pieces after completion of steps b) and c) and, thus, the final coated metal ribbon for connecting solar cells is obtained.

Preferably, the length of the coated metal ribbon is within a range from 100 mm to 600 mm and most preferably within a range from 200 mm to 400 mm.

Optionally the coated metal ribbon comprising a polymer layer and a metal layer after steps b) and c) can be coiled onto a roll (also referred to as reel) after the coating process has been completed. More preferably, the coated metal ribbon is rolled up after completion of steps b) and c) and is only unrolled and cut to the length required for the specific application during the method for producing a photovoltaic component.

In a third aspect of the invention the invention relates to a solar cell comprising a coated metal ribbon of the invention.

In a further aspect the invention refers to a photovoltaic component comprising a first solar cell electrode and a further element, wherein the solar cell electrode and the further element are connected to each other by a coated metal ribbon according to the invention. Preferably, the first solar cell electrode of the photovoltaic component is a front contact or a back contact electrode. Preferably, a solar cell includes at least one semiconductor layer which is contacted by at least two solar cell electrodes having opposite polarities. Preferably, the semiconductor layer is a doped silicon wafer. Preferably, the semiconductor layer is a monocrystalline or a multicrystalline silicon wafer. Typically, the at least two solar cell electrodes of a solar cell are at least one back contact electrode and at least one front contact electrode, which means that the electrodes are arranged on opposites sides of the semiconductor layer. The front contact electrode is located on the light receiving side while the back contact electrode is located on the side facing away from the sun light. In a further embodiment, the at least two electrodes can be arranged on the same side of the semiconductor substrate (also referred to as *back contact solar cell*).

The back contact electrode can, for example, be a metal layer applied over a large area. Preferably, this metal layer includes aluminium with silver-containing contacting points.

Preferably, the front contact electrode of the photovoltaic component is a bus bar. The bus bar can connect a plurality or all of the finger electrodes to each other and serves to efficiently transport the electric current collected by the finger electrodes. At the same time, the bus bar can serve to provide mechanically robust contact areas, e.g., for soldering. Preferably, the bus bar has a greater line cross-section than a finger electrode. The diameter of a bus bar can, preferably, be in a range from 100 µm to 2 mm while its height preferably is in the range from 1 to 20 µm. Those skilled in the art know bus bars of varying designs. A bus bar can be designed as a continuous uniform conductor path, a constricted conductor path (e.g., in the form of a pearl chain) as well as with interruptions.

In a preferred embodiment, a bus bar contacts a plurality, more specifically all of the finger electrodes provided on a solar cell.

In a preferred embodiment of the invention the solar cell electrode, like e.g. a bus bar, can be positioned at the edge of the solar cell substrate. The term "at the edge of the solar cell substrate" may be understood as a distance to the edge of 1 cm or less, preferably 0.5 cm or less.

Both the back contact electrode and the front contact electrode are preferably produced by applying a conductor paste to the semiconductor layer and then firing the applied conductor paste. The conductor paste can be applied to the semiconductor layer by printing, e.g., screen printing or stencil printing. A conductor paste typically comprises electrically conductive metal particles, a glass frit and an organic medium. If the conductor paste is used to produce a back contact electrode, the electrically conductive metal particles preferably contain silver and/or aluminium. If the conductor paste is used to produce a front contact electrode, the electrically conductive metal particles preferably contain or consist of silver. After application, the semiconductor substrate can be fired together with the applied conductor paste(s), thereby obtaining a solar cell electrode. The firing process allows the organic medium to be removed, and a mechanically solid and electrically conductive electrode can be obtained. The obtained solar cell electrodes thus preferably comprise a mixture consisting of glass and metal.

In the photovoltaic component according to the invention, a first solar cell electrode is connected to a further element via the coated metal ribbon according to the invention. Preferably, the further element is a further solar cell electrode of a solar cell. More preferably, the further element is a further solar cell electrode having a polarity that is opposite to that of the first solar cell electrode. For example, the first solar cell and the further solar cell can be identical. Preferably, the coated metal ribbon connects the front contact electrode of the first solar cell to the back contact electrode of the further solar cell. Alternatively, the coated metal ribbon can also connect the back contact electrode of a first solar cell to the front contact electrode of a further solar cell. The photovoltaic component according to the invention can also be part of a chain of solar cells that are connected by the coated metal ribbon, i.e., in addition to the first and the further solar cell electrode, further solar cell electrodes can each be connected to further coated metal ribbons.

In a preferred embodiment, the contact between the first solar cell electrode and the coated metal ribbon is established by a soldered connection. Preferably, the soldered connection is established by fusing at least one region of the metal layer on the coated metal ribbon to the solar cell electrode. Therein, the metal layer on the metal ribbon core establishes the mechanical and electrical contact to the first solar cell electrode.

By the coated metal ribbon according to the invention being partially coated with a polymer layer in the area of contact with the first solar cell electrode and in the area of contact with the further element, it is possible to prevent the finger electrodes from getting into contact with the solder when soldering the solar cell electrode to the coated metal ribbon. In particular, the soldered area formed by the molten solder material is smaller than the area of the solar cell electrode, with the result that liquid solder material preferably does not get into contact with the finger electrodes.

In a particularly preferred embodiment of the invention the coated metal ribbon of the invention is positioned on a solar cell electrode which is positioned at the edge of the solar cell. In this scenario it is particularly preferred if the coated metal ribbon partially overlaps with the solar cell electrode. In this embodiment the part of the coated metal ribbon comprising the polymer layer preferably does not overlap with the solar cell electrode. More preferably the part of the coated metal ribbon comprising the polymer layer extends over the edge of the solar cell substrate. This can lead to reduced shadowing of the active part of the solar cell which can be beneficial to increase the power output of the solar cell.

In a further aspect of the invention, the photovoltaic component according to the invention is produced by a method comprising the following steps:
- providing a solar cell with at least one solar cell electrode, more specifically a bus bar electrode, and providing a further element;
- providing a coated metal ribbon according to the invention;
- positioning the coated metal ribbon relative to the at least one solar cell electrode and the further element;
- connecting the at least one solar cell electrode and the further element by means of the coated metal ribbon, preferably by soldering.

The following section describes the production of a photovoltaic component according to the invention, wherein a solar cell electrode is connected to a further element by means of the coated metal ribbon of the invention. The invention, however, also comprises embodiments in which a solar cell has a plurality of solar cell electrodes, more specifically bus bars, which are each connected to the further element or the further elements via a coated metal ribbon.

In order to produce the photovoltaic component, a solar cell is provided which has at least one solar cell electrode. Preferably, the solar cell comprises at least one front contact electrode, e.g., in the form of a bus bar, and one back contact electrode. The further element preferably is a further solar cell electrode of a second solar cell. In particular, the second solar cell is identical with the first provided solar cell. Alternatively, the further element of the photovoltaic module can also be a connection line for a photovoltaic module. The connection line can serve to extract the electric current from a plurality of solar cells connected in series.

Furthermore, at least one coated metal ribbon according to the invention is provided. Preferably, the coated metal ribbon is provided by being unrolled from a roll. Preferably, this unrolled, coated metal ribbon structure, that has already a polymer layer and a metal layer on its surface, is cut to the required length and thus a coated metal ribbon suitable for the particular application is obtained. In particular, the coated metal ribbon is provided such that the length is sufficient to connect the bus bar of a solar cell to the solar cell electrode of a further solar cell, more specifically a back contact electrode. This means that, in this embodiment, the coated metal ribbon is about twice as long as the length of a solar cell. In a preferred embodiment, the number of provided coated metal ribbons corresponds to the number of bus bars that are provided on the solar cell. In particular, a roll with a coated metal ribbon structure which can be cut to obtain a coated metal ribbon for connecting two solar cells to each other is provided for each provided bus bar.

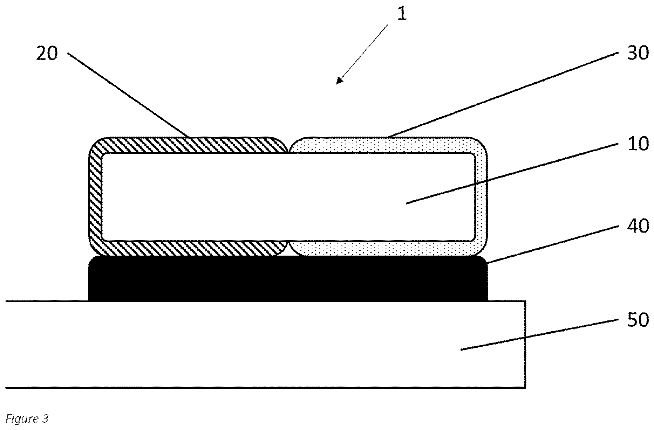

The coated metal ribbon is subsequently positioned relative to the at least one solar cell electrode and the further element. In one embodiment of the invention the coated metal ribbon of the invention is positioned over the busbar in a way that the two have the highest possible overlap. More preferred the coated metal ribbon is positioned symmetrically on the solar cell electrode. In one embodiment of the invention the coated metal ribbon is centered on the solar cell electrode. This configuration is illustrated schematically as a cross-section in Figure 3.

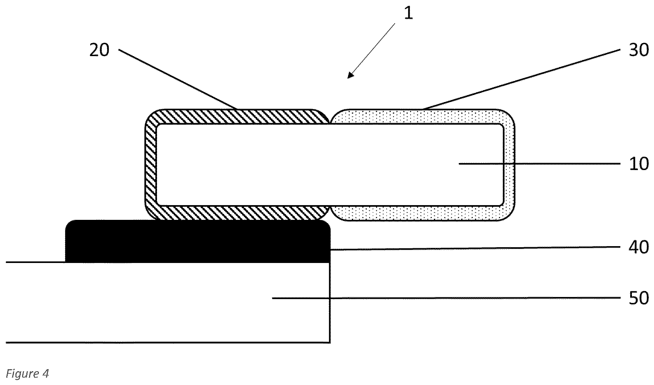

In an alternative embodiment of the invention the coated metal ribbon is positioned on the solar cell such that the two partially overlap. If the two partially overlap the part of the coated metal ribbon comprising the metal layer is in contact with the solar cell electrode. In the scenario of a partial overlap the part of the coated metal ribbon comprising the polymer layer preferably does not contact the solar cell electrode. More preferably the part of the coated metal ribbon comprising the polymer layer does not overlap with the solar cell electrode. This configuration is illustrated schematically as a cross-section in Figure 4. This may reduce the shadowing of the cross-section. Even more preferably the part of the coated metal ribbon comprising the polymer layer does not overlap with the solar cell substrate.

The partially overlapping scenario where the coated metal ribbon partially overlaps with the solar cell electrode is particularly useful, when the solar cell electrode is a bus bar which is positioned at the edge of the solar cell substrate. This can be particularly useful for shingled solar cell modules.

The coated metal ribbon that is positioned on the solar cell electrode and the further element is then connected therewith. The connection is preferably achieved by pressing and soldering the positioned coated metal ribbon. For soldering, the arrangement consisting of the solar cell electrode, the connector and the further element is preferably heated such that the metal layer on the coated metal ribbon melts and a soldered connection to the solar cell electrode is made. The solder material is preferably heated by means of infrared radiation.

### Description of Figures

Figure 1 shows a cross-section of a possible embodiment of the coated metal ribbon according to the invention. The wider sides b and b' correspond to the wider surfaces of the coated metal ribbon and the shorter sides h and h' correspond to the narrower surfaces of the coated metal ribbon. In this example the narrower surfaces are plane. It can be seen that each of the narrower surfaces of the metal ribbon core 10 (corresponding to h,h') is coated with a layer. The narrower surface corresponding to shorter side h is coated with metal layer 20 and the narrower surface corresponding to the shorter side h' is coated with a polymer layer 30. The metal layer and the polymer layer contact each other on the wider surfaces (corresponding to longer sides b, b')
Figure 2 shows a cross-section of a possible embodiment of the coated metal ribbon according to the invention. The wider sides b and b' correspond to the wider surfaces of the coated metal ribbon and the shorter sides h and h' correspond to the narrower surfaces of the coated metal ribbon. In this example the narrower surfaces are rounded. It can be seen that each of the narrower surfaces of the metal ribbon core 10 (corresponding to sides h, h') is coated with a layer. The narrower surface corresponding to shorter side h is coated with metal layer 20 and the narrower surface corresponding to the shorter side h' is coated with a polymer layer 30. The metal layer and the polymer layer contact each other on the wider opposing surfaces (corresponding to longer sides b, b')
Figure 3 illustrates a cross-section of a coated metal ribbon 1 which is positioned symmetrically on a solar cell electrode 40. The coated metal ribbon is centred on the solar cell electrode 40 and does not shadow the solar cell substrate 50.
Figure 4 illustrates a cross-section of a coated metal ribbon 1 which is positioned asymmetrically on a solar cell electrode 40. The coated metal ribbon is partially overlaps with the solar cell electrode 40. The solar cell electrode 40 is positioned at the edge of the solar cell substrate 50. The part of the coated metal ribbon 1 which is coated with the polymer layer extends beyond the solar cell electrode 40 and also extends beyond the solar cell substrate 50. The coated metal ribbon 1 does not shadow the solar cell substrate 50.

### List of reference numbers

1 Coated meal ribbon
10 Metal ribbon core
20 Metal layer
30 polymer layer
40 solar cell electrode
50 solar cell substrate

In the following the general teaching of the invention will be illustrated below by means of exemplary embodiments.

### Examples

### 1) Production of the coated connector:

First, a metal ribbon core was provided in the form of a copper ribbon rolled up on a reel (copper: ETP standard, Rp0.2 = 80 MPa, dimensions: 1.5 mm wide, 200 µm thick). The copper ribbon was unrolled from the reel; then a thermal treatment (soft-annealing) and a reduction of the surface by plasma treatment were performed. The further steps took place in an inert atmosphere (oxygen content < 50 ppm).

Subsequently, UV-curing solder resist (ELPEPCB® SD 2460/201 UV-FLEX) was applied to one narrower surface of the copper ribbon an using an extrusion method. Therein, the ribbon was drawn through a chamber. Inside the chamber, the resist was pressurised. Both inlet and outlet were sealed by a narrow gap such that resist was prevented from flowing out of the chamber. The coating of the narrower surface was carried out continuously by adhesion of the resist during transport through the resist in the chamber. The further narrower surface of the copper ribbon core was prevented from being wetted with resist by means of sealings.

The thickness of the resist coating was 15 µm. The solder resist coated on narrower surface of the copper ribbon such that the layer of solder resist reached to middle of both of the wider surfaces of the copper ribbon respectively. Subsequently, the applied solder resist was cured at a surface temperature of the substrate of approx. 60 °C, using the UV light of a high-pressure vapour mercury lamp. After curing, the layer thickness of the resist layer was approx. 15 µm as well. In the next step, the copper ribbon that was partially coated with solder resist was immersed in a solder bath containing molten solder alloy (Sn60Pb40). Therein, the layer thickness of the solder was determined by the temperature of the solder bath, the feed speed of the copper ribbon and by "wiping off the solder using air knives directly after the leaving the solder bath. After it was drawn out of the solder bath, the copper ribbon was wetted with the solder alloy in those areas that were not wetted with solder resist. The solder resist areas were not wetted with solder alloy. After solidification, the layer of the solder alloy had a layer thickness of about 15 µm. After solidification, the coated copper ribbon was rolled up onto the reel.

### 2) Provision of solar cells

The solar cell used was a p-type cell with an n-emitter by Q-Cells (resistance: 90 ohms/square). The surface had a Si3Nx antireflective coating on the front side. Fingers and three bus bars were applied to the front side by screen printing, using commercially available paste type Heraeus SOL 9631C (Heraeus Deutschland GmbH). The line width of the fingers was 40 µm and the width of the bus bars was 1.5 mm. Screen-printed silver solder pads were applied to the rear side using commercially available paste type Heraeus SOL205B (Heraeus Deutschland GmbH). The aluminium BSF on the back was printed using screen-printed commercially available aluminium paste ((RUX28K30, Guangzhou Ruxing Technology Development Co., Ltd. of Guangdong, China). The pastes were dried and baked in an oven at a maximum temperature of 900 °C.

### 3) Production of photovoltaic modules:

Coated metal ribbons were used to produce photovoltaic modules from two solar cells using the method described below:
A first solar cell was positioned on a mounting surface such that the front contact electrodes with the bus bars were each located on the top.

A coated copper ribbon such as it was made in Example 1 was provided, rolled up on reels. A separate reel with coated copper ribbon was provided for each of the three bus bars per solar cell.

The metal ribbons that were coated with a metal layer and solder resist on the narrower surfaces respectively were unrolled, stretched and passed to the bus bars of the first solar cell via guides. The coated copper ribbons were each positioned and aligned above the three bus bars such that the smallest possible area of the front side of the solar cell was shadowed.

After having been unrolled and positioned above the first solar cell, the coated copper ribbons were cut such that the length of the coated copper ribbons was sufficient for the connection of two adjacent solar cells. This means that the length of a cut coated copper ribbon was about twice as long as the length of the first solar cell. Half of each of the unrolled copper ribbons contacted a bus bar on the front side of the first solar cell while the other half of the connectors projected beyond the solar cell. The second solar cell was placed onto the portions of the three connectors that projected beyond the first solar cell. Therein, the second solar cell was positioned such that the coated copper ribbons contacted the rear side of the second solar cell.

After the second solar cell was positioned, the solar cells and the three connectors were pressed together. Subsequently, the arrangement consisting of the two solar cells and the coated copper ribbons were heated using IR radiation such that the solder material on the coated metal ribbons reached a temperature of about 200°C. After heating, the arrangement was cooled down wherein the molten solder alloy solidified. In this manner, two connected solar cells were obtained.

## Claims

1. Coated metal ribbon for connecting a solar cell, wherein the metal ribbon core has two narrower opposing surfaces and two wider opposing surfaces, wherein a first of the narrower surfaces is coated with a polymer layer and wherein the second narrower surface is coated with a metal layer and wherein the polymer layer and the metal layer are in contact with each other on the two wider opposing surfaces of the metal ribbon core.

2. Coated metal ribbon according to claim 1, wherein the metal layer comprises a solder alloy.

3. Coated metal ribbon according to claim 1 or 2, wherein the polymer layer comprises a solder resist.

4. Coated metal ribbon according to any of claims 1 - 3, wherein the coated metal ribbon has a metal ribbon core that comprises copper.

5. Coated metal ribbon according to any of claims 1 - 4, wherein the polymer layer further comprises inorganic particles having a diameter in the range from 100 nm to 50 µm.

6. Method for producing a coated metal ribbon according to claims 1 - 5 comprising the steps:
a) Providing a metal ribbon core having two narrower opposing surfaces and two wider opposing surfaces,
b) Applying a polymer layer on the first narrower surface of the metal ribbon core
c) Applying a metal layer on the second narrower surface of the metal ribbon core to obtain a coated metal ribbon,
wherein steps b) and c) are performed such that the metal layer and the polymer layer contact each other on both of the wider surfaces of the coated metal ribbon.

7. Method according to claim 6, wherein the metal ribbon core is cleaned before step b) and preferably the cleaning a comprises plasma cleaning.

8. Method according to claim 6 or 7, wherein the polymer layer is applied by printing or immersion.

9. Method according to any of claims 6 - 8, wherein the metal layer is applied galvanically or by immersion.

10. A photovoltaic component, comprising a first solar cell electrode and a further element, wherein the solar cell electrode and the further element are connected to each other by means of a coated metal ribbon according to any one of claims 1-5.

11. A photovoltaic component according to claim 10, wherein the coated metal ribbon is positioned symmetrically on the solar cell electrode.

12. A photovoltaic component according to claim 10 or 11, wherein the coated metal ribbon is positioned on a solar cell electrode such that it partially overlaps with the solar cell electrode and the metal layer is in contact with the solar cell electrode.

13. A photovoltaic component according to any of claims 10 - 12, wherein the solar cell electrode is positioned at the edge of the solar cell substrate and the part of the coated metal ribbon which is coated with the polymer layer extends beyond the edge of the solar cell substrate.
